# EUROPÄISCHE PATENTSCHRIFT

(11) **EP 4 133 166 B1**
(45) Veröffentlichungstag und Bekanntmachung des Hinweises auf die Patenterteilung: **28.08.2024**
(21) Anmeldenummer: 21717309.5
(22) Anmeldetag: 01.04.2021
(51) Int. Cl.: F01N 3/20, F01N 3/28

(54) **ADAPTERANORDNUNG UND BAUTEILVERBUND**
ADAPTOR ARRANGEMENT AND COMPONENT ASSEMBLY
AGENCEMENT D'ADAPTATEUR ET ASSEMBLAGE DE COMPOSANTS

(30) Priorität: 06.04.2020 AT 502922020
(43) Veröffentlichungstag der Anmeldung: 15.02.2023
(73) Patentinhaber: RENAULT S.A.S., 92100 Boulogne-Billancourt (FR)
(72) Erfinder: REITER, Bernd, 8010 Kainbach bei Graz (AT); LAWLOR, Vincent, 8510 Stainz (AT); MAKINSON, Julian, 8044 Graz (AT)
(86) Internationale Anmeldenummer: PCT/AT2021/060111
(87) Internationale Veröffentlichungsnummer: WO 2021/203152

(56) Entgegenhaltungen:
- DE-A1- 19 627 840
- DE-B- 1 127 422
- JP-A- H0 932 533
- JP-A- H07 208 154
- JP-A- H07 259 543

## Beschreibung

Die vorliegende Erfindung betrifft eine Adapteranordnung zum gasdichten Leiten von elektrischem Strom in einen Gasbehälter. Ferner betrifft die Erfindung einen Bauteilverbund mit einem Gasbehälter und einer Adapteranordnung zur Unterstützung eines stromdichten Leitens von elektrischem Strom in den Gasbehälter.

Im Stand der Technik ist es bekannt, für den Startbetrieb eines Brennstoffzellensystems eine elektrische Heizvorrichtungen zu verwenden, um das Brennstoffzellensystem, insbesondere einen Brennstoffzellenstapel des Brennstoffzellensystems, möglichst schnell auf die gewünschte Betriebstemperatur zu bringen. Als Heizvorrichtungen sind elektrisch beheizbare Metallkatalysatoren bekannt. Diese weisen ein Katalysatorgehäuse auf, in welchem sich Katalysatormaterial befindet, das durch eine elektrisch betreibbare Hilfsvorrichtung schnell auf eine gewünschte Betriebstemperatur gebracht werden kann. Der Strom für die sich im Katalysatorgehäuse positionierte Hilfsvorrichtung wird durch einen über das Katalysatorgehäuse hinausragenden Stromanschluss in das Katalysatorgehäuse geleitet. In der Praxis hat sich nun gezeigt, dass die Dichtung am Stromanschluss zur Vermeidung eines Gasaustritts aus dem Katalysatorgehäuse während eines Funktionsbetriebs des Katalysators nicht den gewünschten Anforderungen entspricht. Genauer gesagt konnte bei unterschiedlichen Versuchen jeweils ein Gasaustritt im Bereich des Stromanschlusses festgestellt werden.

JP H07 208154 A, JP H07 259543 A, JP H09 032533 A, DE 1 127 422 A und DE 196 27 840 A1 offenbaren jeweils eine Anordnung mit einer gasdichten elektrischen Durchführung durch einen Wandabschnitt.

Aufgabe der vorliegenden Erfindung ist es, der voranstehend beschriebenen Problematik zumindest teilweise Rechnung zu tragen. Insbesondere ist es Aufgabe der vorliegenden Erfindung, ein Hilfsmittel zum gasdichten Leiten von elektrischem Strom in einen Gasbehälter, insbesondere in Form eines wie einleitend beschriebenen Metallkatalysators, zu schaffen.

Die voranstehende Aufgabe wird durch die Patentansprüche gelöst. Insbesondere wird die voranstehende Aufgabe durch die Adapteranordnung gemäß Anspruch 1, die Adapteranordnung gemäß Anspruch 7 sowie den Bauteilverbund gemäß Anspruch 15 gelöst. Weitere Vorteile der Erfindung ergeben sich aus den Unteransprüchen, der Beschreibung und den Zeichnungen. Dabei gelten Merkmale und Details, die im Zusammenhang mit den Adapteranordnungen beschrieben sind, selbstverständlich auch im Zusammenhang mit dem erfindungsgemäßen Bauteilverbund und jeweils umgekehrt, sodass bezüglich der Offenbarung zu den einzelnen Erfindungsaspekten stets wechselseitig Bezug genommen wird bzw. werden kann.

Gemäß einem ersten Aspekt der vorliegenden Erfindung wird eine Adapteranordnung, zum gasdichten Leiten von elektrischem Strom in einen Gasbehälter, zur Verfügung gestellt, wobei der Gasbehälter einen vorsprungartigen Stromanschluss umfasst, der sich, zum Leiten des elektrischen Stroms in den Gasbehälter, von einem Innenvolumen des Gasbehälters über eine Außenfläche des Gasbehälters hinaus erstreckt. Die Adapteranordnung umfasst:
- ein Gehäuse zum wenigstens teilweisen Umschließen des Stromanschlusses in einer Umfangsrichtung des Stromanschlusses, wobei das Gehäuse einen Deckel mit einer Durchgangsöffnung für ein kontaktfreies Herausführen des Stromanschlusses aus dem Gehäuse aufweist,
- ein Behälter-Dichtmittel zum gasdichten Befestigen des Gehäuses am Gasbehälter,
- ein Lagermittel zum Befestigen am Stromanschluss innerhalb des Gehäuses,
- ein erstes Isoliermittel zum Positionieren zumindest teilweise zwischen dem Lagermittel und dem Deckel innerhalb des Gehäuses für eine elektrische Isolierung zwischen dem Lagermittel und dem Deckel,
- ein Gehäuse-Dichtmittel zum Befestigen an dem aus dem Gehäuse herausgeführten Stromanschluss zum Abdichten einer Lücke zwischen dem Stromanschluss und dem Deckel, und
- ein zweites Isoliermittel zum Positionieren zumindest teilweise zwischen dem Gehäuse-Dichtmittel und dem Deckel außerhalb des Gehäuses für eine elektrische Isolierung zwischen dem Gehäuse-Dichtmittel und dem Deckel.

Mittels der erfindungsgemäßen Adapteranordnung ist es auf einfache und zuverlässige Weise möglich, gasdicht Strom in den Gasbehälter zu leiten. D.h., es kann verhindert werden, dass Gas aus dem Gasbehälter über die Adapteranordnung hinaus in die Umgebung des Gasbehälters austritt, während der Strom in den Gasbehälter geleitet wird. Unter dem Gasbehälter kann ein Katalysatorgehäuse eines elektrisch beheizbaren Katalysators, insbesondere eines Metallkatalysators wie beispielsweise eines Emicats, verstanden werden.

Die erfindungsgemäße Adapteranordnung lässt sich mit einfachen Mitteln realisieren. Neben Standardbauteilen können zur Umsetzung der Adapteranordnung einfache geometrische Körper, beispielsweise ein einfacher Hohlzylinder für das Gehäuse, genutzt werden. Dadurch kann die Fertigung der Adapteranordnung schnell und kostengünstig realisiert werden. Ferner lässt sich die Adapteranordnung auf relativ kleinem Bauraum realisieren.

Das Gehäuse kann einen Gehäusemantelabschnitt aufweisen, der ich zumindest abschnittsweise mantelförmig um den Stromanschluss herum erstreckt. Der Gehäusemantelabschnitt ist vorzugsweise zylinder- und/oder röhrenförmig ausgestaltet. Darunter, dass das Gehäuse den Stromanschluss wenigstens teilweise umschließt, kann verstanden werden, dass sich das Gehäuse und/oder der Gehäusemantelabschnitt nur um einen Teil des Stromanschlusses in Längsrichtung des Stromanschlusses herum erstreckt. Dass das Gehäuse zum wenigstens teilweisen Umschließen des Stromanschlusses in einer Umfangsrichtung des Stromanschlusses ausgestaltet ist kann verstanden werden, dass das Gehäuse den Stromanschluss in einer Längsrichtung des Stromanschlusses mantelförmig umgibt.

Der Deckel ist, losgelöst von einem wie vorstehend beschriebenen Gehäusemantelabschnitt betrachtet, vorzugsweise scheibenförmig und/oder plattenförmig mit einer vorzugsweise zentral darin ausgestalteten Durchgangsöffnung konfiguriert. Besonders bevorzugt können der Gehäusemantelabschnitt und der Deckel als an wenigstens einer Stelle stoffschlüssig miteinander verbundene Bauteile bereitgestellt sein. Damit kann das Anbringen der Adapteranordnung am Gasbehälter vereinfacht werden.

Unter dem kontaktfreien Herausführen des Stromanschlusses aus dem Gehäuse ist ein Herausführen des Stromanschlusses aus dem Gehäuse ohne direkten mechanischen Kontakt zwischen dem Stromanschluss und dem Gehäuse zu verstehen. Da der Stromanschluss sowie das Gehäuse vorzugsweise aus Metall und/oder einem elektrisch leitfähigen Material bestehen, können damit ein Kurzschluss und/oder eine andere elektrische Fehlfunktion verhindert werden.

Ein Durchmesser und/oder eine Dimension der Durchgangsöffnung sind entsprechend größer als der Durchmesser und/oder die Dimension eines vorliegenden und/oder gewünschten Stromanschlusses im Bereich der Durchgangsöffnung gewählt.

Unter dem Behälter-Dichtmittel kann ein Mittel zum stoffschlüssigen Verbinden des Gehäuses mit dem Gasbehälter verstanden werden. Das Behälter-Dichtmittel weist vorzugsweise eine Schweißnaht auf, durch welche das Gehäuse am Gasbehälter, insbesondere wenigstens an der Außenfläche des Gasbehälters, befestigt werden kann. Das Behälter-Dichtmittel wird vorzugsweise bereitgestellt, um den Bereich, in welchem das Gehäuse am Gasbehälter befestigt wird, gasdicht zu gestalten. D.h., das Behälter-Dichtmittel muss nicht den gesamten Behälter gegen einen Gasaustritt abdichten.

Das Lagermittel dient zur Fixierung des ersten Isoliermittels in der gewünschten Position. Das Lagermittel kann mithin als Gegenlager zum Deckel, genauer gesagt zu einer Innenseite des Deckels, die in ein Innenvolumen des Gehäuses zeigt, verstanden werden. Das Lagermittel kann zur Positionierung des ersten Isoliermittels direkt am ersten Isoliermittel, bevorzugt mit direktem Flächenkontakt zwischen dem Lagermittel und dem ersten Isoliermittel, positioniert werden.

Unter dem Abdichten der Lücke kann ein gasdichtes Verschließen wenigstens einer Lücke zwischen dem Stromanschluss und dem Deckel, die sich durch das kontaktfreie Herausführen des Stromanschlusses aus dem Gehäuse durch die Durchgangsöffnung ergibt, verstanden werden. D.h., das Gehäuse-Dichtmittel ist vorzugsweise zum Verhindern eines Gasaustritts aus dem Gehäuse konfiguriert. Das Verhindern des Gasaustritts kann direkt oder indirekt bewirkt werden. So kann das Gehäuse-Dichtmittel die Lücke direkt oder durch Hilfsmittel wie das zweite Isoliermittel gasdicht verschließen.

Das erste Isoliermittel und das zweite Isoliermittel kann jeweils einen scheibenförmigen Isolierring aufweisen oder als scheibenförmiger Isolierring, zum ringförmigen Anordnen um den Stromanschluss, ausgestaltet sein. Das erste Isoliermittel und/oder das zweite Isoliermittel kann jeweils zum Abdichten des Behälters gegen einen Gasaustritt aus dem Gehäuse ausgestaltet sein.

Das erste Isoliermittel und/oder das zweite Isoliermittel kann entsprechend aus elastischem Kunststoff bestehen oder einen entsprechenden elastischen Kunststoff aufweisen. Das erste Dichtmittel und/oder das zweite Dichtmittel ist bevorzugt jeweils einstückig ausgestaltet. Das Isoliermittel kann in einer bevorzugten Ausführungsform jedoch auch aus einem formstabilen, elektrisch nicht leitendem Material, beispielsweise aus Keramik, bestehen oder dieses Material für die elektrische Isolierfunktion zumindest entsprechend aufweisen.

Gemäß einer weiteren Ausführungsform der vorliegenden Erfindung ist es möglich, dass bei einer Adapteranordnung der Stromanschluss einen ersten Stromanschluss-Gewindeabschnitt aufweist und das Lagermittel wenigstens eine Mutter zum Aufdrehen auf den ersten Gewindeabschnitt aufweist. Damit kann das Lagermittel besonders einfach und kostengünstig zur Verfügung gestellt werden. Bevorzugt weist das Lagermittel zwei Muttern auf, wobei eine Mutter als Kontermutter dient. Unter dem Aufdrehen kann ein Aufschrauben, ein Einschrauben oder ein Aufdrehen verstanden werden. Der Gewindeabschnitt kann mithin ein Außengewinde oder ein Innengewinde aufweisen. Der erste Stromanschluss-Gewindeabschnitt ist bevorzugt als Innengewinde an einer Innenumfangsfläche des Lagermittels und/oder der wenigstens einen Mutter ausgestaltet oder weist entsprechend ein Innengewinde auf, das auf ein korrespondierendes Außengewinde des Stromanschlusses aufgeschraubt werden kann.

Ferner ist es möglich, dass bei einer Adapteranordnung gemäß der vorliegenden Erfindung der Stromanschluss einen zweiten Stromanschluss-Gewindeabschnitt aufweist und das Gehäuse-Dichtmittel wenigstens eine Mutter zum Aufdrehen auf den zweiten Gewindeabschnitt aufweist. D.h., die Mutter kann auf den zweiten Gewindeabschnitt aufgedreht werden. Auch damit lässt sich die Adapteranordnung relativ einfach und kostengünstig gestalten. Die wenigstens eine Mutter des Gehäuse-Dichtmittels kann beispielsweise auf das zweite Isoliermittel gedreht werden, bis sich ein gasdichter Verschluss zum Abdichten des Gehäuses ergibt. Das Gehäuse-Dichtmittel kann eine weitere Mutter aufweisen, die zur Fixierung der ersten Mutter des Gehäuse-Dichtmittels als Kontermutter auf den zweiten Stromanschluss-Gewindeabschnitt gedreht werden kann.

Von weiterem Vorteil ist es, wenn eine erfindungsgemäße Adapteranordnung ein Spannmittel aufweist, das zur Druckbeaufschlagung des ersten Isoliermittels in Richtung des Deckels zumindest teilweise zwischen dem Lagermittel und dem ersten Isoliermittel angeordnet ist.

Damit lässt sich eine einfache Positionierung des ersten Isoliermittels an einer gewünschten Position am Deckel, genauer gesagt an einer Innenseite des Deckels, erreichen. Das Spannmittel kann ein einstückiges Federelement aufweisen. Das Spannmittel ist zum Aufschieben auf den Stromanschluss bevorzugt ringförmig ausgestaltet. Eine erfindungsgemäße Adapteranordnung kann ferner wenigstens eine ringförmige Unterlegscheibe zur Positionierung zwischen dem Lagermittel und dem ersten Isoliermittel, zwischen dem Gehäuse-Dichtmittel und dem zweiten Isoliermittel und/oder zwischen dem Lagermittel und dem Spannmittel und/oder zwischen dem Spannmittel und dem ersten Isoliermittel aufweisen. Damit lassen sich die Kräfte auf die jeweiligen Bauteile auf kostengünstige und sichere Weise einfach, zuverlässig und effektiv übertragen. Unter einer Ringform ist vorliegend bevorzugt eine Form zu verstehen, die durch zwei konzentrisch zueinander angeordnete, im Querschnitt kreisförmige Mantelabschnitte gebildet wird. Gleichwohl können eine Außenumfangsfläche und/oder eine Innenumfangsfläche einer erfindungsgemäßen Ringform auch elliptisch und/oder eckig, beispielsweise sechseckig wie eine Mutter, ausgestaltet sein. Die Isoliermittel sind jeweils bevorzugt scheibenförmig, also mit einer ebenen oder im Wesentlichen ebenen Oberseite und einer ebenen Unterseite, ausgestaltet.

Gemäß einer weiteren Ausgestaltungsvariante der vorliegenden Erfindung ist es möglich, dass eine Adapteranordnung ein elastisch verformbares erstes Stromleitmittel mit einem Stromleitmittel-Befestigungsabschnitt zum Befestigen des ersten Stromleitmittels außerhalb des Gehäuses am Stromanschluss zum Abgreifen von Strom vom Stromanschluss über das erste Stromleitmittel aufweist. Durch das erste Stromleitmittel können auf einfache und kostengünstige Weise thermisch bedingte Größenunterschiede des Gasbehälters, des Stromanschlusses und/oder des Gehäuses ausgeglichen werden. Der Stromleitmittel-Befestigungsabschnitt weist vorzugweise einen Stromleitmittel-Gewindeabschnitt, insbesondere ein Innengewinde im und/oder am Stromleitmittel, zum Aufdrehen des Stromleitmittels auf den Stromanschluss, auf.

Das erste Stromleitmittel ist vorzugsweise plattenförmig oder im Wesentlichen plattenförmig ausgestaltet. D.h., eine Länge und eine Breite des Stromleitmittels sind jeweils um ein vielfaches länger und/oder höher als eine Höhe des Stromleitmittels. Außerdem weist das Stromleitmittel bevorzugt eine ebene oder im Wesentlichen ebene Oberseite und eine ebene oder im Wesentlichen ebene Unterseite auf.

Das Stromleitmittel kann, insbesondere mit Bezug auf die Außenkontur des Stromleitmittels, quaderförmig oder im Wesentlichen quaderförmig ausgestaltet sein.

Darüber hinaus kann eine Adapteranordnung gemäß der vorliegenden Erfindung ein Fixiermittel, zum zerstörungsfrei lösbaren Fixieren des ersten Stromleitmittels am Stromanschluss zumindest teilweise zwischen dem Fixiermittel und dem Gehäuse-Dichtmittel, aufweisen. Durch das Fixiermittel können der Zusammenbau sowie ein Auseinanderbauen im Wartungs- und/oder Reparaturfall besonders einfach durchgeführt werden. Bei einer Adapteranordnung gemäß der vorliegenden Erfindung kann es von Vorteil sein, wenn der Stromanschluss einen zweiten Stromanschluss-Gewindeabschnitt aufweist und das Fixiermittel wenigstens eine Mutter zum Aufdrehen auf den zweiten Stromanschluss-Gewindeabschnitt aufweist.

Gemäß einem weiteren Aspekt der vorliegenden Erfindung wird eine Adapteranordnung zum gasdichten Leiten von elektrischem Strom in einen Gasbehälter zur Verfügung gestellt, wobei der Gasbehälter einen vorsprungartigen Stromanschluss umfasst, der sich, zum Leiten des elektrischen Stroms in den Gasbehälter, von einem Innenvolumen des Gasbehälters über eine Außenfläche des Gasbehälters hinaus erstreckt. Diese Adapteranordnung umfasst:
- ein Gehäuse zum wenigstens teilweisen Umschließen des Stromanschlusses in einer Umfangsrichtung des Stromanschlusses, wobei das Gehäuse einen Deckel mit einer Durchgangsöffnung aufweist,
- ein Verbindungsbauteil mit einem Verbindungsbauteil-Befestigungsabschnitt zum Befestigen des Verbindungsbauteils am Stromanschluss für einen elektrischen Kontakt zwischen dem Stromanschluss und dem Verbindungsbauteil und zum Leiten des elektrischen Stroms über das Verbindungsteil durch den Stromanschluss in den Gasbehälter, wobei die Durchgangsöffnung für ein kontaktloses Herausführen des am Stromanschluss befestigten Verbindungsbauteils aus dem Gehäuse ausgestaltet ist,
- ein Behälter-Dichtmittel zum gasdichten Befestigen des Gehäuses am Gasbehälter,
- ein Lagermittel, das innerhalb des Gehäuses am Verbindungsbauteil befestigt ist
- ein erstes Isoliermittel, das zumindest teilweise zwischen dem Lagermittel und dem Deckel innerhalb des Gehäuses für eine elektrische Isolierung zwischen dem Lagermittel und dem Deckel positioniert ist,
- ein Gehäuse-Dichtmittel, das an einem aus dem Gehäuse herausgeführten Abschnitt des Verbindungsbauteils zum Abdichten einer Lücke zwischen dem Verbindungsbauteil und dem Deckel befestigt ist, und
- ein zweites Isoliermittel, das zumindest teilweise zwischen dem Gehäuse-Dichtmittel und dem Deckel außerhalb des Gehäuses für eine elektrische Isolierung zwischen dem Gehäuse-Dichtmittel und dem Deckel positioniert ist.

Die Adapteranordnung gemäß diesem Aspekt entspricht im Wesentlichen der Ausführungsform gemäß dem ersten Aspekt, wobei das Gehäuse nicht um den Stromanschluss, sondern um das Verbindungsbauteil herum abgedichtet wird. Dies hat den Vorteil, dass die Adapteranordnung noch einfacher und/oder flexibler an unterschiedlichen Gasbehältern und/oder Stromanschlüssen verwendet und/oder montiert werden kann. Die vorstehend mit Bezug auf die Adapteranordnung am Stromanschluss im Bereich des Gehäuses und insbesondere im Bereich der Durchgangsöffnung beschriebenen Merkmale treffen auf analoge Weise auf die Adapteranordnung gemäß dem zweiten Aspekt und mit Bezug auf das Verbindungsbauteil zu.

So ist es bei einer Adapteranordnung gemäß dem zweiten Aspekt beispielsweise möglich, dass das Verbindungsbauteil einen ersten Verbindungsbauteil-Gewindeabschnitt aufweist und das Lagermittel wenigstens eine Mutter zum Aufdrehen auf den ersten Gewindeabschnitt aufweist. Ferner ist es möglich, dass das Verbindungsbauteil einen zweiten Verbindungsbauteil-Gewindeabschnitt aufweist und das Gehäuse-Dichtmittel wenigstens eine Mutter zum Aufdrehen auf den zweiten Verbindungsbauteil-Gewindeabschnitt aufweist.

Die Adapteranordnung mit Verbindungsbauteil weist ebenso ein Spannmittel auf, das zur Druckbeaufschlagung des ersten Isoliermittels in Richtung des Deckels zumindest teilweise zwischen dem Lagermittel und dem ersten Isoliermittel angeordnet ist.

Das elastisch verformbare erste Stromleitmittel kann den Stromleitmittel-Befestigungsabschnitt zum Befestigen des ersten Stromleitmittels außerhalb des Gehäuses am Verbindungsbauteil zum Abgreifen von Strom von dem Verbindungsbauteil über das erste Stromleitmittel aufweisen. Das Fixiermittel kann zum zerstörungsfrei lösbaren Fixieren des ersten Stromleitmittels am Verbindungsbauteil zumindest teilweise zwischen dem Fixiermittel und dem Gehäuse-Dichtmittel konfiguriert sein.

Darüber hinaus ist es bei einer Adapteranordnung gemäß dem zweiten Aspekt möglich, dass das Verbindungsbauteil einen zweiten Verbindungsbauteil-Gewindeabschnitt aufweist und das Fixiermittel wenigstens eine Mutter zum Aufdrehen auf den zweiten Verbindungsbauteil-Gewindeabschnitt aufweist. Der Verbindungsbauteil-Befestigungsabschnitt kann einen dritten Verbindungsbauteil-Gewindeabschnitt zum Aufdrehen des Verbindungsbauteils auf einen korrespondierenden Stromanschluss-Gewindeabschnitt des Stromanschlusses aufweisen. Damit lässt sich das Verbindungsbauteil schnell, einfach und zuverlässig mit dem Stromanschluss verbinden. Der dritte Verbindungsbauteil-Gewindeabschnitt weist vorzugsweise ein Innengewinde auf, das auf ein korrespondierendes Außengewinde des Stromanschlusses geschraubt werden kann.

Gemäß einer weiteren Ausgestaltungsvariante der vorliegenden Erfindung ist es möglich, dass das Verbindungsbauteil bei einer Adapteranordnung gemäß dem zweiten Aspekt einstückig, insbesondere stift- und/oder zapfenförmig, ausgestaltet ist. Die Adapteranordnung kann damit besonders stabil, platzsparend und kostengünstig zur Verfügung gestellt werden.

Von weiterem Vorteil kann es sein, wenn das Verbindungsbauteil bei einer Adapteranordnung gemäß der vorliegenden Erfindung einen vierten Verbindungsbauteil-Gewindeabschnitt an einer Stirnseite des Verbindungsbauteils, für eine Schraubverbindung zwischen einem weiteren Stromanschluss und dem Verbindungsbauteil, aufweist.

Damit lässt sich auf platzsparende und einfache Weise ein Stromanschlussabschnitt zum Anbinden eines weiteren Stromanschlusses an das Verbindungsbauteil außerhalb des Gehäuses realisieren.

Ferner kann eine Adapteranordnung gemäß der vorliegenden Erfindung ein elastisch verformbares zweites Stromleitmittel aufweisen, wobei der Stromanschluss und das Verbindungsbauteil für eine elektrische Verbindung zwischen dem Stromanschluss und dem Verbindungsbauteil durch das zweite Stromleitmittel mechanisch miteinander verbunden sind. Durch das zweite Stromleitmittel können auf einfache und kostengünstige Weise thermisch bedingte Größenunterschiede des Gasbehälters, des Stromanschlusses, des Verbindungsbauteils und/oder des Gehäuses ausgeglichen werden. Das zweite Stromleitmittel weist vorzugweise einen ersten Stromleitmittel-Gewindeabschnitt und/oder einen zweiten Stromleitmittel-Gewindeabschnitt auf, die jeweils insbesondere ein Innengewinde im und/oder am zweiten Stromleitmittel aufweisen. Durch die Gewindeabschnitte kann das zweite Stromleitmittel einfach mit dem Stromanschluss und/oder dem Verbindungsbauteil zum Herstellen der gewünschten elektrischen Verbindung zwischen dem Stromanschluss, dem zweiten Stromleitmittel und dem Verbindungsbauteil, verbunden werden.

Das zweite Stromleitmittel ist bevorzugt plattenförmig oder im Wesentlichen plattenförmig ausgestaltet. Außerdem weist das zweite Stromleitmittel bevorzugt eine ebene oder im Wesentlichen ebene Oberseite und eine ebene oder im Wesentlichen ebene Unterseite auf. Das Stromleitmittel kann, insbesondere mit Bezug auf die Außenkontur des Stromleitmittels, quaderförmig oder im Wesentlichen quaderförmig ausgestaltet sein.

Gemäß einem weiteren Aspekt der vorliegenden Erfindung wird ein Bauteilverbund zur Verfügung gestellt. Der Bauteilverbund weist einen Gasbehälter mit einer Außenfläche und einem vorsprungartigen Stromanschluss auf, wobei sich der Stromanschluss, zum Leiten eines elektrischen Stroms in den Gasbehälter, von einem Innenvolumen des Gasbehälters über die Außenfläche des Gasbehälters hinaus erstreckt. Ferner weist der Bauteilverbund eine an der Außenfläche sowie am Stromanschluss befestigte und wie vorstehend im Detail beschriebene Adapteranordnung auf.

Damit bringt ein erfindungsgemäßer Bauteilverbund die gleichen Vorteile mit sich, wie sie ausführlich mit Bezug auf die erfindungsgemäße Adapteranordnung beschrieben worden sind. Der Stromanschluss ist bevorzugt stift- und/oder zapfenförmig ausgestaltet.

Weitere, die Erfindung verbessernde Maßnahmen ergeben sich aus der nachfolgenden Beschreibung zu verschiedenen Ausführungsbeispielen der Erfindung, welche in den Figuren schematisch dargestellt sind.

Es zeigen jeweils schematisch:
- Figur 1: eine Adapteranordnung gemäß einer ersten Ausführungsform der vorliegenden Erfindung,
- Figur 2: eine Adapteranordnung gemäß einer zweiten Ausführungsform der vorliegenden Erfindung,
- Figur 3: ein erfindungsgemäßes Verbindungsbauteil,
- Figur 4: eine Adapteranordnung gemäß einer dritten Ausführungsform der vorliegenden Erfindung,
- Figur 5: eine Adapteranordnung gemäß einer vierten Ausführungsform der vorliegenden Erfindung,
- Figur 6: eine Adapteranordnung gemäß einer fünften Ausführungsform der vorliegenden Erfindung,
- Figur 7: eine Adapteranordnung gemäß einer sechsten Ausführungsform der vorliegenden Erfindung,
- Figur 8: einen Bauteilverbund gemäß einer bevorzugten Ausführungsform der vorliegenden Erfindung in einer Schnittdarstellung, und
- Figur 9: eine perspektivische Gesamtansicht des in Fig. 8 dargestellten Bauteilverbunds.

Elemente mit gleicher Funktion und Wirkungsweise sind in den Figuren jeweils mit den gleichen Bezugszeichen versehen.

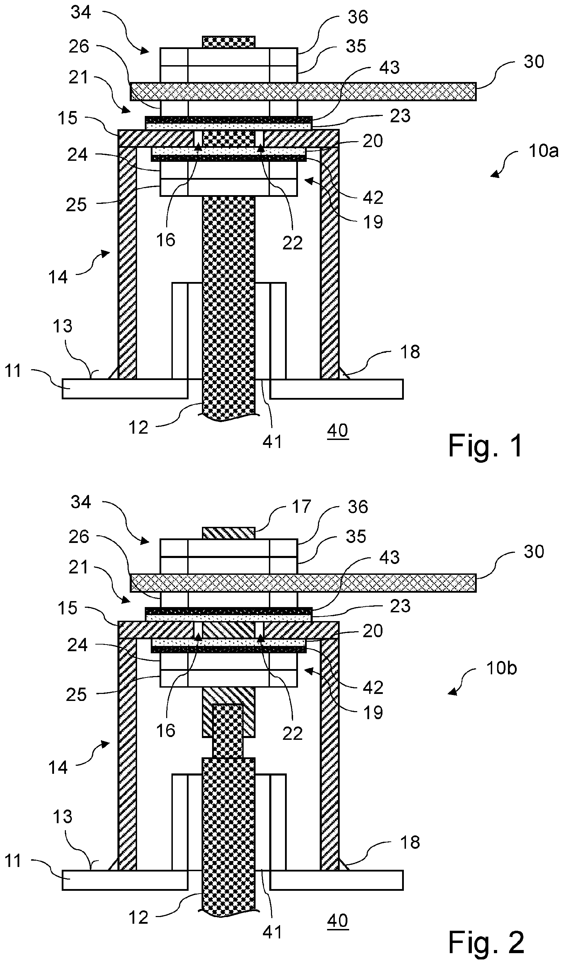

Fig. 1 zeigt eine Adapteranordnung 10a zum gasdichten Leiten von elektrischem Strom in einen Gasbehälter 11 gemäß einer ersten Ausführungsform. Der Gasbehälter 11 weist einen stiftförmigen, vorsprungartigen Stromanschluss 12 auf, der sich, zum Leiten des elektrischen Stroms in den Gasbehälter 11, von einem Innenvolumen 40 des Gasbehälters 11 über eine Außenfläche 13 des Gasbehälters 11 hinaus erstreckt. Die Adapteranordnung 10a weist ein Gehäuse 14 zum Umschließen des Stromanschlusses 12 in einer Umfangsrichtung des Stromanschlusses 12 in dem Bereich, in welchem der Stromanschluss 12 aus dem Gasbehälter 11 ragt, auf. Das Gehäuse 14 weist einen Deckel 15 mit einer Durchgangsöffnung 16 für ein kontaktfreies Herausführen des Stromanschlusses 12 aus dem Gehäuse 14 auf. Die Adapteranordnung 10a weist ferner ein Behälter-Dichtmittel 18 in Form einer Schweißnaht zum gasdichten Befestigen des Gehäuses 14 am Gasbehälter 11 auf. D.h., das Gehäuse 14 ist durch die Schweißnaht des Behälter-Dichtmittels 18 am Gasbehälter 11 stoffschlüssig angebunden. Außerdem weist die Adapteranordnung 10a ein innerhalb des Gehäuses 14 am Stromanschluss 12 befestigtes Lagermittel 19 auf. Das in Fig. 1 dargestellte Lagermittel 19 weist eine erste Mutter 24 und eine Kontermutter 25 auf, die jeweils auf einen korrespondierenden Gewindeabschnitt des Stromanschlusses 12 gedreht sind. Ferner weist die gezeigte Adapteranordnung 10a ein erstes Isoliermittel 20 auf, das zwischen dem Lagermittel 19 und dem Deckel 15 innerhalb des Gehäuses 14 für eine elektrische Isolierung zwischen dem Lagermittel 19 und dem Deckel 15 positioniert ist. Die Adapteranordnung 10a weist zudem ein Gehäuse-Dichtmittel 21 auf, das an dem aus dem Gehäuse 14 herausgeführten Stromanschluss 12 befestigt ist, um eine Lücke 22 zwischen dem Stromanschluss 12 und dem Deckel 15 gegen Gasaustritt aus dem Innenvolumen 40 abzudichten. Darüber hinaus weist die gezeigte Adapteranordnung 10a ein zweites Isoliermittel 23 auf, das zwischen dem Gehäuse-Dichtmittel 21 und dem Deckel 15 außerhalb des Gehäuses 14 für eine elektrische Isolierung zwischen dem Gehäuse-Dichtmittel 21 und dem Deckel 15 positioniert ist.

Das erste Isoliermittel 20 und das zweite Isoliermittel 23 sind jeweils ringscheibenförmig ausgestaltet. Das Gehäuse-Dichtmittel 21 weist wenigstens eine Mutter 26 auf, die auf einen zweiten Stromanschluss-Gewindeabschnitt des Stromanschlusses 12 gedreht und dort befestigt ist.

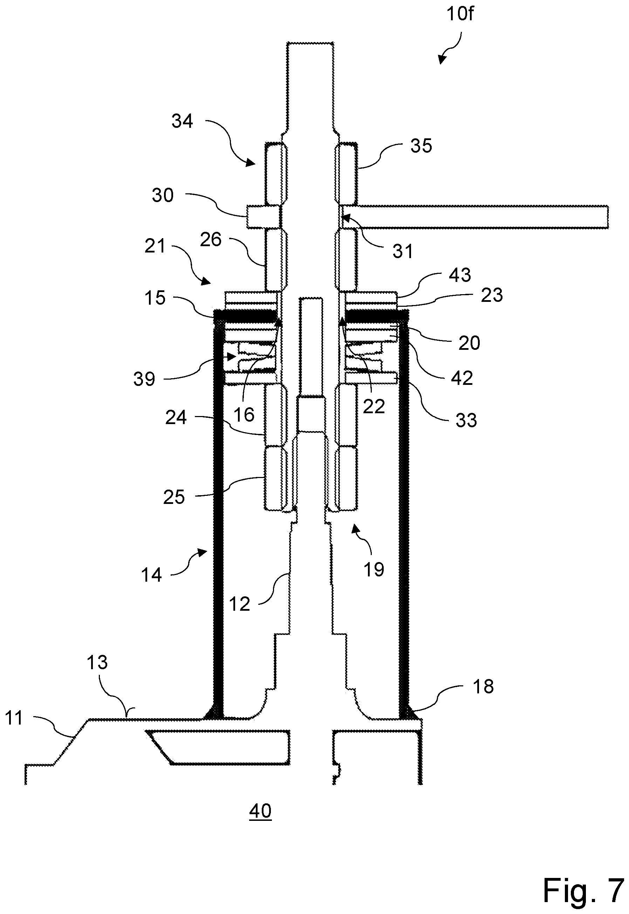

Die in Fig. 1 dargestellte Adapteranordnung 10a weist ferner ein elastisch verformbares erstes Stromleitmittel 30 mit einem in Fig. 7 dargestellten Stromleitmittel-Befestigungsabschnitt 31 auf, durch welchen das erste Stromleitmittel 30 außerhalb des Gehäuses 14 am Stromanschluss 12 befestigt ist, sodass Strom vom Stromanschluss 17 über das erste Stromleitmittel 30 geleitet werden kann. Der Stromleitmittel-Befestigungsabschnitt 31 ist im gezeigten Beispiel in Form eines Gewindeabschnitts ausgestaltet, durch welchen das erste Stromleitmittel 30 an einem korrespondierenden Gewinde des Stromanschlusses 12 befestigt ist.

Die gezeigte Adapteranordnung 10a weist zudem ein Fixiermittel 34 in Form einer ersten Mutter 35 und einer zweiten Mutter 36 in Form einer zum zerstörungsfrei lösbaren Fixieren des ersten Stromleitmittels 30 am Stromanschluss 12 zwischen dem Fixiermittel 34 und dem Gehäuse-Dichtmittel 21 auf. Das dargestellte Stromleitmittel 30 ist demnach zwischen der Mutter 26 des Gehäuse-Dichtmittels 21 und der Mutter 35 des Fixiermittels 34 eingespannt.

Bei dem gezeigten Beispiel sind zwischen dem ersten Isoliermittel 20 und dem Deckel 15 eine erste Unterlegscheibe 42 und zwischen dem zweiten Isoliermittel 23 und der Mutter 26 eine zweite Unterlegscheibe 43 angeordnet. In einem Bereich, in welchem der Stromanschluss 12 aus dem Gasbehälter 11 geführt wird, ist ein drittes Isoliermittel 41 angeordnet, durch welches der Stromanschluss 12 vom Gasbehälter 11 elektrisch isoliert ist.

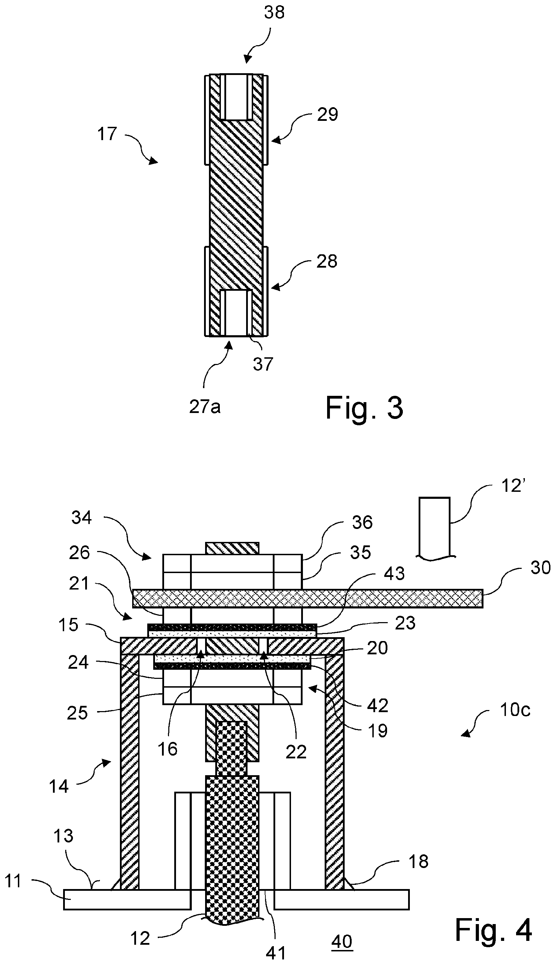

In Fig. 2 ist eine Adapteranordnung 10b gemäß einer zweiten Ausführungsform dargestellt. Die in Fig. 2 gezeigte Adapteranordnung 10b unterscheidet sich von der in Fig. 1 gezeigten Adapteranordnung 10a insbesondere durch ein einstückiges Verbindungsbauteil 17. Das dargestellte Verbindungsbauteil 17 weist einen in Fig. 3 dargestellten Verbindungsbauteil-Befestigungsabschnitt 27a zum Befestigen des Verbindungsbauteils 17 am Stromanschluss 12 auf, um einen elektrischen Kontakt zwischen dem Stromanschluss 12 und dem Verbindungsbauteil 17 herzustellen und um den elektrischen Strom über das Verbindungsteil 17 durch den Stromanschluss 12 in den Gasbehälter 11 zu leiten. Die Durchgangsöffnung 16 ist entsprechend für ein kontaktloses Herausführen des am Stromanschluss 12 befestigten Verbindungsbauteils 17 aus dem Gehäuse 14 ausgestaltet.

Das Gehäuse-Dichtmittel 21 ist an einem aus dem Gehäuse 14 herausgeführten Abschnitt des Verbindungsbauteils 17 befestigt, um eine Lücke 22 zwischen dem Verbindungsbauteil 17 und dem Deckel 15 abzudichten.

Das Verbindungsbauteil 17 weist einen in Fig. 3 dargestellten ersten Verbindungsbauteil-Gewindeabschnitt 28 auf, an welchem das Lagermittel 19 in Form der beiden Muttern 24, 25 befestigt ist. Das Verbindungsbauteil 17 weist einen ebenfalls in Fig. 3 dargestellten zweiten Verbindungsbauteil-Gewindeabschnitt 29 auf, an welchem das Gehäuse-Dichtmittel 21 in Form der Mutter 26 befestigt ist. Am zweiten Verbindungsbauteil-Gewindeabschnitt 29 ist ferner das Fixiermittel 34 in Form der beiden Muttern 35, 36 befestigt.

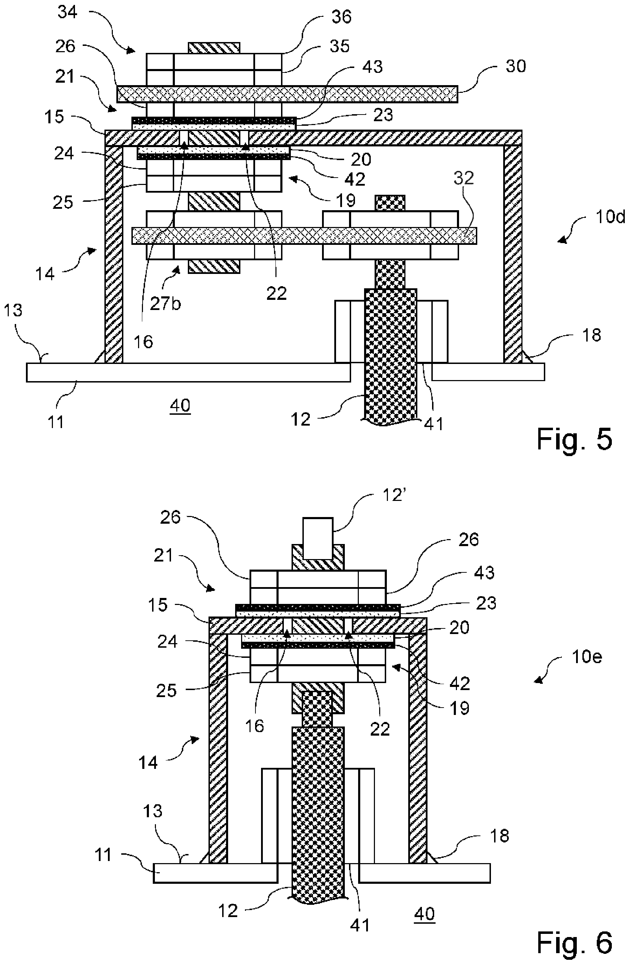

In Fig. 3 ist ein zapfenförmiges Verbindungsbauteil 17 dargestellt, an welchem der Verbindungsbauteil-Befestigungsabschnitt 27a, ein zugehöriger dritter Verbindungsbauteil-Gewindeabschnitt 37, ein erster Verbindungsbauteil-Gewindeabschnitt 28, ein zweiter Verbindungsbauteil-Gewindeabschnitt 29 sowie ein vierter Verbindungsbauteil-Gewindeabschnitt 38 ausgestaltet sind. Der Verbindungsbauteil-Gewindeabschnitt 37 ist zum Aufdrehen des Verbindungsbauteils 17 auf einen korrespondierenden Stromanschluss-Gewindeabschnitt des Stromanschlusses 12 ausgestaltet. Der vierte Verbindungsbauteil-Gewindeabschnitt 38 ist an einer Stirnseite des Verbindungsbauteils 17 für eine Schraubverbindung zwischen einem in Fig. 6 dargestellten weiteren Stromanschluss 12' und dem Verbindungsbauteil 17 ausgestaltet.

Fig. 4 zeigt eine Adapteranordnung 10c gemäß einer dritten Ausführungsform. In dieser Ausführungsform ist ein weiterer Stromanschluss 12' dargestellt, der am ersten Stromleitmittel befestigbar ist.

In Fig. 5 ist eine Adapteranordnung 10d gemäß einer vierten Ausführungsform dargestellt. Diese Ausführungsform ist durch ein elastisch verformbares zweites Stromleitmittel 32 gekennzeichnet, wobei der Stromanschluss 12 und das Verbindungsbauteil 17 für eine elektrische Verbindung zwischen dem Stromanschluss 12 und dem Verbindungsbauteil 17 durch das zweite Stromleitmittel 32 mechanisch miteinander verbunden sind.

Das zweite Stromleitmittel 32 ist in der dargestellten Ausführungsform plattenförmig oder im Wesentlichen plattenförmig ausgestaltet und sowohl am Verbindungsbauteil 17, genauer gesagt an einem Verbindungsbauteil-Befestigungsabschnitt 27b des Verbindungsbauteils 17, als auch am Stromanschluss 12 jeweils durch zwei Muttern gesichert.

Fig. 6 zeigt eine Adapteranordnung 10e gemäß einer fünften Ausführungsform, bei welcher im vierten Verbindungsbauteil-Gewindeabschnitt 38 an der Stirnseite des Verbindungsbauteils 17 ein weiterer Stromanschluss 12' eingeschraubt ist.

In Fig. 7 ist eine Adapteranordnung 10f gemäß einer sechsten Ausführungsform dargestellt, die sich von den anderen Ausführungsformen erfindungsgemäss durch ein Spannmittel 39 unterscheidet, das zur Druckbeaufschlagung des ersten Isoliermittels 20 in Richtung des Deckels 15 zwischen dem Lagermittel 19 und dem ersten Isoliermittel 20 angeordnet ist. Das Spannmittel 39 ist zwischen einer ersten Unterlegscheibe 42 und einer dritten Unterlegscheibe 33 eingespannt.

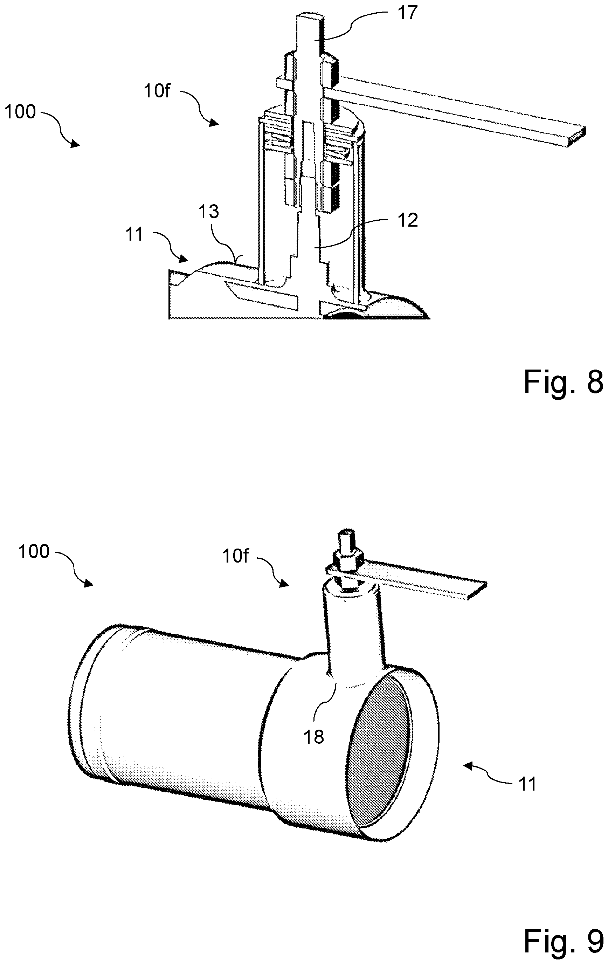

Fig. 8 zeigt einen Bauteilverbund 100, der einen wie vorstehend beschriebenen Gasbehälter 11 mit einer Außenfläche 13 und einem vorsprungartigen Stromanschluss 12 umfasst, der sich, zum Leiten des elektrischen Stroms in den Gasbehälter 11, über die Außenfläche 13 des Gasbehälters 11 hinaus erstreckt. Der Bauteilverbund 100 umfasst ferner eine wie in Fig. 7 dargestellte Adapteranordnung 10f, die durch ein Behälter-Dichtmittel 18 in Form einer Schweißnaht an der Außenfläche 13 sowie am Verbindungsbauteil 17 befestigt ist. In Fig. 9 ist der in Fig. 8 dargestellte Bauteilverbund 100 in einer perspektivischen Gesamtansicht dargestellt. Der Gasbehälter 11 ist in der gezeigten Ausführungsform als Katalysatorgehäuse eines elektrisch beheizbaren Metallkatalysators ausgestaltet. Die Erfindung lässt neben den dargestellten Ausführungsformen weitere Gestaltungsgrundsätze zu. D. h. die Erfindung soll nicht auf die mit Bezug auf die Figuren erläuterten Ausführungsbeispiele beschränkt betrachtet werden.

### Bezugszeichenliste

- 10a - 10f: Adapteranordnung
- 11: Gasbehälter
- 12: Stromanschluss
- 13: Außenfläche
- 14: Gehäuse
- 15: Deckel
- 16: Durchgangsöffnung
- 17: Verbindungsbauteil
- 18: Behälter-Dichtmittel
- 19: Lagermittel
- 20: erstes Isoliermittel
- 21: Gehäuse-Dichtmittel
- 22: Lücke
- 23: zweites Isoliermittel
- 24: Mutter
- 25: Mutter
- 26: Mutter
- 27a: Verbindungsbauteil-Befestigungsabschnitt
- 27b: Verbindungsbauteil-Befestigungsabschnitt
- 28: erster Verbindungsbauteil-Gewindeabschnitt
- 29: zweiter Verbindungsbauteil-Gewindeabschnitt
- 30: erstes Stromleitmittel
- 31: Stromleitmittel-Befestigungsabschnitt
- 32: zweites Stromleitmittel
- 33: dritte Unterlegscheibe
- 34: Fixiermittel
- 35: Mutter
- 36: Mutter
- 37: dritter Verbindungsbauteil-Gewindeabschnitt
- 38: vierter Verbindungsbauteil-Gewindeabschnitt
- 39: Spannmittel
- 40: Innenvolumen
- 41: drittes Isoliermittel
- 42: erste Unterlegscheibe
- 43: zweite Unterlegscheibe
- 100: Bauteilverbund

## Patentansprüche

1. Adapteranordnung (10a; 10b; 10c; 10d; 10e; 10f) zum gasdichten Leiten von elektrischem Strom in einen Gasbehälter (11), wobei der Gasbehälter (11) einen vorsprungartigen Stromanschluss (12) umfasst, der sich, zum Leiten des elektrischen Stroms in den Gasbehälter (11), von einem Innenvolumen (40) des Gasbehälters (11) über eine Außenfläche (13) des Gasbehälters (11) hinaus erstreckt, aufweisend:
- ein Gehäuse (14) zum wenigstens teilweisen Umschließen des Stromanschlusses (12) in einer Umfangsrichtung des Stromanschlusses (12), wobei das Gehäuse (14) einen Deckel (15) mit einer Durchgangsöffnung (16) für ein kontaktfreies Herausführen des Stromanschlusses (12) aus dem Gehäuse (14) aufweist,
- ein Behälter-Dichtmittel (18) zum gasdichten Befestigen des Gehäuses (14) am Gasbehälter (11),
- ein Lagermittel (19) zum Befestigen am Stromanschluss (12) innerhalb des Gehäuses (14),
- ein erstes Isoliermittel (20) zum Positionieren zumindest teilweise zwischen dem Lagermittel (19) und dem Deckel (15) innerhalb des Gehäuses (14) für eine elektrische Isolierung zwischen dem Lagermittel (19) und dem Deckel (15),
- ein Gehäuse-Dichtmittel (21) zum Befestigen an dem aus dem Gehäuse (14) herausgeführten Stromanschluss (12) zum Abdichten einer Lücke (22) zwischen dem Stromanschluss (12) und dem Deckel (15), und
- ein zweites Isoliermittel (23) zum Positionieren zumindest teilweise zwischen dem Gehäuse-Dichtmittel (21) und dem Deckel (15) außerhalb des Gehäuses (14) für eine elektrische Isolierung zwischen dem Gehäuse-Dichtmittel (21) und dem Deckel (15),
**gekennzeichnet durch**
ein Spannmittel (39), das zur Druckbeaufschlagung des ersten Isoliermittels (20) in Richtung des Deckels (15) zumindest teilweise zwischen dem Lagermittel (19) und dem ersten Isoliermittel (20) angeordnet ist.

2. Adapteranordnung (10a; 10b; 10c; 10d; 10e; 10f) nach Anspruch 1, wobei der Stromanschluss (12) einen ersten Stromanschluss-Gewindeabschnitt aufweist und das Lagermittel (19) wenigstens eine Mutter (24, 25) zum Aufdrehen auf den ersten Stromanschluss-Gewindeabschnitt aufweist.

3. Adapteranordnung (10a; 10b; 10c; 10d; 10e; 10f) nach einem der voranstehenden Ansprüche,
wobei der Stromanschluss (12) einen zweiten Stromanschluss-Gewindeabschnitt aufweist und das Gehäuse-Dichtmittel (21) wenigstens eine Mutter (26) zum Aufdrehen auf den zweiten Stromanschluss-Gewindeabschnitt aufweist.

4. Adapteranordnung (10a; 10b; 10c; 10d; 10e; 10f) nach einem der voranstehenden Ansprüche,
aufweisend ein elastisch verformbares erstes Stromleitmittel (30) mit einem Stromleitmittel-Befestigungsabschnitt (31) zum Befestigen des ersten Stromleitmittels (30) außerhalb des Gehäuses (14) am Stromanschluss (12) zum Abgreifen von Strom vom Stromanschluss (17) über das erste Stromleitmittel (30).

5. Adapteranordnung (10a; 10b; 10c; 10d; 10e; 10f) nach Anspruch 4, aufweisend ein Fixiermittel (34) zum zerstörungsfrei lösbaren Fixieren des ersten Stromleitmittels (30) am Stromanschluss (12) zumindest teilweise zwischen dem Fixiermittel (34) und dem Gehäuse-Dichtmittel (21).

6. Adapteranordnung (10a; 10b; 10c; 10d; 10e; 10f) nach Anspruch 5, wobei der Stromanschluss (12) einen zweiten Stromanschluss-Gewindeabschnitt aufweist und das Fixiermittel (34) wenigstens eine Mutter (35, 36) zum Aufdrehen auf den zweiten Stromanschluss-Gewindeabschnitt aufweist.

7. Adapteranordnung (10b; 10c; 10d; 10e; 10f) zum gasdichten Leiten von elektrischem Strom in einen Gasbehälter (11), wobei der Gasbehälter (11) einen vorsprungartigen Stromanschluss (12) umfasst, der sich, zum Leiten des elektrischen Stroms in den Gasbehälter (11), von einem Innenvolumen (40) des Gasbehälters (11) über eine Außenfläche (13) des Gasbehälters (11) hinaus erstreckt, aufweisend:
- ein Gehäuse (14) zum wenigstens teilweisen Umschließen des Stromanschlusses (12) in einer Umfangsrichtung des Stromanschlusses (12), wobei das Gehäuse (14) einen Deckel (15) mit einer Durchgangsöffnung (16) aufweist,
- ein Verbindungsbauteil (17) mit einem Verbindungsbauteil-Befestigungsabschnitt (27a; 27b) zum Befestigen des Verbindungsbauteils (17) am Stromanschluss (12) für einen elektrischen Kontakt zwischen dem Stromanschluss (12) und dem Verbindungsbauteil (17) und zum Leiten des elektrischen Stroms über das Verbindungsteil (17) durch den Stromanschluss (12) in den Gasbehälter (11), wobei die Durchgangsöffnung (16) für ein kontaktloses Herausführen des am Stromanschluss (12) befestigten Verbindungsbauteils (17) aus dem Gehäuse (14) ausgestaltet ist,
- ein Behälter-Dichtmittel (18) zum gasdichten Befestigen des Gehäuses (14) am Gasbehälter (11),
- ein Lagermittel (19), das innerhalb des Gehäuses (14) am Verbindungsbauteil (17) befestigt ist
- ein erstes Isoliermittel (20), das zumindest teilweise zwischen dem Lagermittel (19) und dem Deckel (15) innerhalb des Gehäuses (14) für eine elektrische Isolierung zwischen dem Lagermittel (19) und dem Deckel (15) positioniert ist,
- ein Gehäuse-Dichtmittel (21), das an einem aus dem Gehäuse (14) herausgeführten Abschnitt des Verbindungsbauteils (17) zum Abdichten einer Lücke (22) zwischen dem Verbindungsbauteil (17) und dem Deckel (15) befestigt ist, und
- ein zweites Isoliermittel (23), das zumindest teilweise zwischen dem Gehäuse-Dichtmittel (21) und dem Deckel (15) außerhalb des Gehäuses (14) für eine elektrische Isolierung zwischen dem Gehäuse-Dichtmittel (21) und dem Deckel (15) positioniert ist,
**gekennzeichnet durch**
ein Spannmittel (39), das zur Druckbeaufschlagung des ersten Isoliermittels (20) in Richtung des Deckels (15) zumindest teilweise zwischen dem Lagermittel (19) und dem ersten Isoliermittel (20) angeordnet ist.

8. Adapteranordnung (10b; 10c; 10d; 10e; 10f) nach Anspruch 7,
wobei das Verbindungsbauteil (17) einen ersten Verbindungsbauteil-Gewindeabschnitt (28) aufweist und das Lagermittel (19) wenigstens eine Mutter (24, 25) zum Aufdrehen auf den ersten Gewindeabschnitt (28) aufweist.

9. Adapteranordnung (10b; 10c; 10d; 10e; 10f) nach einem der Ansprüche 7 bis 8, wobei das Verbindungsbauteil (17) einen zweiten Verbindungsbauteil-Gewindeabschnitt (29) aufweist und das Gehäuse-Dichtmittel (21) wenigstens eine Mutter (26) zum Aufdrehen auf den zweiten Verbindungsbauteil-Gewindeabschnitt (29) aufweist.

10. Adapteranordnung (10b; 10c; 10d; 10f) nach einem der Ansprüche 7 bis 9, aufweisend ein elastisch verformbares erstes Stromleitmittel (30) mit einem Stromleitmittel-Befestigungsabschnitt (31) zum Befestigen des ersten Stromleitmittels (30) außerhalb des Gehäuses (14) am Verbindungsbauteil (17) zum Abgreifen von Strom von dem Verbindungsbauteil (17) über das erste Stromleitmittel (30).

11. Adapteranordnung (10b; 10c; 10d; 10f) nach Anspruch 10,
aufweisend ein Fixiermittel (34) zum zerstörungsfrei lösbaren Fixieren des ersten Stromleitmittels (30) am Verbindungsbauteil (17) zumindest teilweise zwischen dem Fixiermittel (34) und dem Gehäuse-Dichtmittel (21).

12. Adapteranordnung (10b; 10c; 10e; 10f) nach einem der Ansprüche 7 bis 11, wobei der Verbindungsbauteil-Befestigungsabschnitt (27a) einen dritten Verbindungsbauteil-Gewindeabschnitt (37) zum Aufdrehen des Verbindungsbauteils (17) auf einen korrespondierenden Stromanschluss-Gewindeabschnitt des Stromanschlusses (12) aufweist.

13. Adapteranordnung (10b; 10c; 10d; 10e; 10f) nach einem der Ansprüche 7 bis 12,
wobei das Verbindungsbauteil (17) einstückig ausgestaltet ist.

14. Adapteranordnung (10d) nach einem der Ansprüche 7 bis 13,
aufweisend ein elastisch verformbares zweites Stromleitmittel (32), wobei der Stromanschluss (12) und das Verbindungsbauteil (17) für eine elektrische Verbindung zwischen dem Stromanschluss (12) und dem Verbindungsbauteil (17) durch das zweite Stromleitmittel (32) mechanisch miteinander verbunden sind.

15. Bauteilverbund (100), aufweisend einen Gasbehälter (11) mit einer Außenfläche (13) und einem vorsprungartigen Stromanschluss (12), wobei sich der Stromanschluss (12), zum Leiten eines elektrischen Stroms in den Gasbehälter (11), von einem Innenvolumen (40) des Gasbehälters (11) über die Außenfläche (13) des Gasbehälters (11) hinaus erstreckt, und einer an der Außenfläche (13) sowie am Stromanschluss (12) befestigten Adapteranordnung (10d) nach einem der voranstehenden Ansprüche.

## Claims

1. Adapter arrangement (10a; 10b; 10c; 10d; 10e; 10f) for the gas-tight conducting of electrical current into a gas container (11), wherein the gas container (11) comprises a projection-like current connection (12), which, for conducting the electrical current into the gas container (11), extends from an inner volume (40) of the gas container (11) beyond an outer surface (13) of the gas container (11), having:
- a housing (14) for at least partially enclosing the current connection (12) in a circumferential direction of the current connection (12), wherein the housing (14) has a cover (15) with a through-opening (16) for leading the current connection (12) out of the housing (14) in a contact-free manner,
- a container sealing means (18) for the gas-tight fastening of the housing (14) to the gas container (11),
- a bearing means (19) for fastening to the current connection (12) within the housing (14),
- a first insulating means (20) for positioning at least partially between the bearing means (19) and the cover (15) within the housing (14) for electrical insulation between the bearing means (19) and the cover (15),
- a housing sealing means (21) for fastening to the current connection (12) led out of the housing (14) for sealing a gap (22) between the current connection (12) and the cover (15), and
- a second insulating means (23) for positioning at least partially between the housing sealing means (21) and the cover (15) outside the housing (14) for electrical insulation between the housing sealing means (21) and the cover (15),
**characterized by**
a clamping means (39), which is arranged at least partially between the bearing means (19) and the first insulating means (20) for applying pressure to the first insulating means (20) in the direction of the cover (15).

2. Adapter arrangement (10a; 10b; 10c; 10d; 10e; 10f) according to Claim 1,
wherein the current connection (12) has a first current-connection threaded portion and the bearing means (19) has at least one nut (24, 25) for the screwing onto the first current-connection threaded portion.

3. Adapter arrangement (10a; 10b; 10c; 10d; 10e; 10f) according to one of the preceding claims,
wherein the current connection (12) has a second current-connection threaded portion and the housing sealing means (21) has at least one nut (26) for the screwing onto the second current-connection threaded portion.

4. Adapter arrangement (10a; 10b; 10c; 10d; 10e; 10f) according to one of the preceding claims,
having an elastically deformable first current conducting means (30) with a current-conducting-means fastening portion (31) for fastening the first current conducting means (30) outside the housing (14) to the current connection (12) for tapping current from the current connection (17) by way of the first current conducting means (30).

5. Adapter arrangement (10a; 10b; 10c; 10d; 10e; 10f) according to Claim 4,
having a fixing means (34) for the non-destructively releasable fixing of the first current conducting means (30) to the current connection (12) at least partially between the fixing means (34) and the housing sealing means (21).

6. Adapter arrangement (10a; 10b; 10c; 10d; 10e; 10f) according to Claim 5,
wherein the current connection (12) has a second current-connection threaded portion and the fixing means (34) has at least one nut (35, 36) for the screwing onto the second current-connection threaded portion.

7. Adapter arrangement (10b; 10c; 10d; 10e; 10f) for the gas-tight conducting of electrical current into a gas container (11), wherein the gas container (11) comprises a projection-like current connection (12), which, for conducting the electrical current into the gas container (11), extends from an inner volume (40) of the gas container (11) beyond an outer surface (13) of the gas container (11), having:
- a housing (14) for at least partially enclosing the current connection (12) in a circumferential direction of the current connection (12), wherein the housing (14) has a cover (15) with a through-opening (16),
- a connecting component (17) with a connecting-component fastening portion (27a; 27b) for fastening the connecting component (17) to the current connection (12) for an electrical contact between the current connection (12) and the connecting component (17) and for conducting the electrical current by way of the connecting part (17) through the current connection (12) into the gas container (11), wherein the through-opening (16) is designed for leading the connecting component (17) fastened to the current connection (12) out of the housing (14) in a contact-free manner,
- a container sealing means (18) for the gas-tight fastening of the housing (14) to the gas container (11),
- a bearing means (19), which is fastened to the connecting component (17) within the housing (14),
- a first insulating means (20), which is positioned at least partially between the bearing means (19) and the cover (15) within the housing (14) for electrical insulation between the bearing means (19) and the cover (15),
- a housing sealing means (21), which is fastened to a portion of the connecting component (17) led out of the housing (14) for sealing a gap (22) between the connecting component (17) and the cover (15), and
- a second insulating means (23), which is positioned at least partially between the housing sealing means (21) and the cover (15) outside the housing (14) for electrical insulation between the housing sealing means (21) and the cover (15),
**characterized by**
a clamping means (39), which is arranged at least partially between the bearing means (19) and the first insulating means (20) for applying pressure to the first insulating means (20) in the direction of the cover (15).

8. Adapter arrangement (10b; 10c; 10d; 10e; 10f) according to Claim 7,
wherein the connecting component (17) has a first connecting-component threaded portion (28) and the bearing means (19) has at least one nut (24, 25) for the screwing onto the first threaded portion (28).

9. Adapter arrangement (10b; 10c; 10d; 10e; 10f) according to either of Claims 7 and 8,
wherein the connecting component (17) has a second connecting-component threaded portion (29) and the housing sealing means (21) has at least one nut (26) for the screwing onto the second connecting-component threaded portion (29).

10. Adapter arrangement (10b; 10c; 10d; 10f) according to one of Claims 7 to 9,
having an elastically deformable first current conducting means (30) with a current-conducting-means fastening portion (31) for fastening the first current conducting means (30) outside the housing (14) to the connecting component (17) for tapping current from the connecting component (17) by way of the first current conducting means (30).

11. Adapter arrangement (10b; 10c; 10d; 10f) according to Claim 10,
having a fixing means (34) for the non-destructively releasable fixing of the first current conducting means (30) to the connecting component (17) at least partially between the fixing means (34) and the housing sealing means (21).

12. Adapter arrangement (10b; 10c; 10e; 10f) according to one of Claims 7 to 11,
wherein the connecting-component fastening portion (27a) has a third connecting-component threaded portion (37) for the screwing of the connecting component (17) onto a corresponding current-connection threaded portion of the current connection (12).

13. Adapter arrangement (10b; 10c; 10d; 10e; 10f) according to one of Claims 7 to 12,
wherein the connecting component (17) is designed as one piece.

14. Adapter arrangement (10d) according to one of Claims 7 to 13,
having an elastically deformable second current conducting means (32), wherein the current connection (12) and the connecting component (17) are mechanically connected to one another for an electrical connection between the current connection (12) and the connecting component (17) by the second current conducting means (32) .

15. Component assembly (100), having a gas container (11) with an outer surface (13) and a projection-like current connection (12), wherein, for conducting an electrical current into the gas container (11), the current connection (12) extends from an inner volume (40) of the gas container (11) beyond the outer surface (13) of the gas container (11), and an adapter arrangement (10d) according to one of the preceding claims fastened to the outer surface (13) and also to the current connection (12).

## Revendications

1. Agencement d'adaptateur (10a ; 10b ; 10c ; 10d ; 10e ; 10f) pour l'acheminement étanche au gaz d'un courant électrique dans un récipient de gaz (11), dans lequel le récipient de gaz (11) comprend une connexion de courant de type saillie (12) qui, pour l'acheminement du courant électrique dans le récipient de gaz (11), s'étend à partir d'un volume interne (40) du récipient de gaz (11) au-delà d'une surface extérieure (13) du récipient de gaz (11), comportant :
- un boîtier (14) pour enfermer au moins partiellement la connexion de courant (12) dans une direction circonférentielle de la connexion de courant (12), le boîtier (14) comportant un couvercle (15) doté d'une ouverture traversante (16) pour faire passer la connexion de courant (12) hors du boîtier (14) de manière sans contact,
- un moyen d'étanchéité de récipient (18) pour la fixation étanche au gaz du boîtier (14) au récipient de gaz (11),
- un moyen de support (19) destiné à être fixé à la connexion de courant (12) à l'intérieur du boîtier (14),
- un premier moyen isolant (20) destiné à être positionné au moins partiellement entre le moyen de support (19) et le couvercle (15) à l'intérieur du boîtier (14) pour une isolation électrique entre le moyen de support (19) et le couvercle (15),
- un moyen d'étanchéité de boîtier (21) destiné à être fixé à la connexion de courant (12) sortant du boîtier (14) afin d'assurer l'étanchéité d'un espace (22) entre la connexion de courant (12) et le couvercle (15), et
- un deuxième moyen isolant (23) destiné à être positionné au moins partiellement entre le moyen de support (21) et le couvercle (15) à l'extérieur du boîtier (14) pour une isolation électrique entre le moyen d'étanchéité de boîtier (21) et le couvercle (15),
**caractérisé par**
un moyen de serrage (39) qui est disposé au moins partiellement entre le moyen de support (19) et le premier moyen d'isolation (20) pour exercer une pression sur le premier moyen d'isolation (20) en direction du couvercle (15).

2. Agencement d'adaptateur (10a ; 10b ; 10c ; 10d ; 10e ; 10f) selon la revendication 1,
dans lequel la connexion de courant (12) comporte une première partie filetée de connexion de courant et le moyen de support (19) comporte au moins un écrou (24, 25) destiné à être vissé sur la première partie filetée de connexion de courant.

3. Agencement d'adaptateur (10a ; 10b ; 10c ; 10d ; 10e ; 10f) selon l'une des revendications précédentes, dans lequel la connexion de courant (12) comporte une deuxième partie filetée de connexion de courant et le moyen d'étanchéité de boîtier (21) comporte au moins un écrou (26) destiné à être vissé sur la deuxième partie filetée de connexion de courant.

4. Agencement d'adaptateur (10a ; 10b ; 10c ; 10d ; 10e ; 10f) selon l'une des revendications précédentes, comportant un premier moyen d'acheminement de courant élastiquement déformable (30) doté d'une partie de fixation de moyen d'acheminement de courant (31) permettant de fixer le premier moyen d'acheminement de courant (30) à l'extérieur du boîtier (14) à la connexion de courant (12) afin de prélever du courant à partir de la connexion de courant (17) par l'intermédiaire du premier moyen d'acheminement de courant (30).

5. Agencement d'adaptateur (10a ; 10b ; 10c ; 10d ; 10e ; 10f) selon la revendication 4,
comportant un moyen de fixation (34) destiné à fixer de manière non destructive et amovible le premier moyen d'acheminement de courant (30) à la connexion de courant (12) au moins partiellement entre le moyen de fixation (34) et le moyen d'étanchéité de boîtier (21).

6. Agencement d'adaptateur (10a ; 10b ; 10c ; 10d ; 10e ; 10f) selon la revendication 5,
dans lequel la connexion de courant (12) comporte une deuxième partie filetée de connexion de courant et le moyen de fixation (34) comporte au moins un écrou (35, 36) destiné à être vissé sur la deuxième partie filetée de connexion de courant.

7. Agencement d'adaptateur (10b ; 10c ; 10d ; 10e ; 10f) pour l'acheminement étanche au gaz d'un courant électrique dans un récipient de gaz (11), dans lequel le récipient de gaz (11) comprend une connexion de courant de type saillie (12) qui, pour l'acheminement du courant électrique dans le récipient de gaz (11), s'étend à partir d'un volume interne (40) du récipient de gaz (11) au-delà d'une surface extérieure (13) du récipient de gaz (11), comportant :
- un boîtier (14) pour enfermer au moins partiellement la connexion de courant (12) dans une direction circonférentielle de la connexion de courant (12), le boîtier (14) comportant un couvercle (15) doté d'une ouverture traversante (16),
- un composant de raccordement (17) comprenant une partie de fixation de composant de raccordement (27a ; 27b) destinée à fixer le composant de raccordement (17) à la connexion de courant (12) pour un contact électrique entre la connexion de courant (12) et le composant de raccordement (17) et à acheminer le courant par l'intermédiaire du composant de raccordement (17) à travers la connexion de courant (12) dans le récipient de gaz (11), l'ouverture traversante (16) étant conçue pour faire sortir sans contact le composant de raccordement (17) fixé à la connexion de courant (12) hors du boîtier (14),
- un moyen d'étanchéité de récipient (18) pour la fixation étanche au gaz du boîtier (14) au récipient de gaz (11),
- un moyen de support (19) qui est fixé au composant de raccordement (17) à l'intérieur du boîtier (14),
- un premier moyen isolant (20) qui est positionné au moins partiellement entre le moyen de support (19) et le couvercle (15) à l'intérieur du boîtier (14) pour une isolation électrique entre le moyen de support (19) et le couvercle (15),
- un moyen d'étanchéité de boîtier (21) qui est fixé à une partie du composant de raccordement (17) partant du boîtier (14) afin d'assurer l'étanchéité d'un espace (22) entre le composant de raccordement (17) et le couvercle (15), et
- un deuxième moyen isolant (23) qui est positionné au moins partiellement entre le moyen de support (21) et le couvercle (15) à l'extérieur du boîtier (14) pour une isolation électrique entre le moyen d'étanchéité de boîtier (21) et le couvercle (15),
**caractérisé par**
un moyen de serrage (39) qui est disposé au moins partiellement entre le moyen de support (19) et le premier moyen d'isolation (20) pour exercer une pression sur le premier moyen d'isolation (20) en direction du couvercle (15).

8. Agencement d'adaptateur (10b ; 10c ; 10d ; 10e ; 10f) selon la revendication 7,
dans lequel le composant de raccordement (17) comporte une première partie filetée de composant de raccordement (28) et le moyen de support (19) comporte au moins un écrou (24, 25) destiné à être vissé sur la première partie filetée (28).

9. Agencement d'adaptateur (10b ; 10c ; 10d ; 10e ; 10f) selon l'une des revendications 7 à 8,
dans lequel le composant de raccordement (17) comporte une deuxième partie filetée de composant de raccordement (29) et le moyen d'étanchéité de boîtier (21) comporte au moins un écrou (26) destiné à être vissé sur la deuxième partie filetée de composant de raccordement (29) .

10. Agencement d'adaptateur (10b ; 10c ; 10d ; 10f) selon l'une des revendications 7 à 9,
comportant un premier moyen d'acheminement de courant élastiquement déformable (30) doté d'une partie de fixation de moyen d'acheminement de courant (31) permettant de fixer le premier moyen d'acheminement de courant (30) à l'extérieur du boîtier (14) au composant de raccordement (17) afin de prélever du courant à partir du composant de raccordement (17) par l'intermédiaire du premier moyen d'acheminement de courant (30).

11. Agencement d'adaptateur (10b ; 10c ; 10d ; 10f) selon la revendication 10,
comportant un moyen de fixation (34) destiné à fixer de manière non destructive et amovible le premier moyen d'acheminement de courant (30) au composant de raccordement (17) au moins partiellement entre le moyen de fixation (34) et le moyen d'étanchéité de boîtier (21) .

12. Agencement d'adaptateur (10b ; 10c ; 10e ; 10f) selon l'une des revendications 7 à 11,
dans lequel la partie de fixation de composant de raccordement (27a) comporte une troisième partie filetée de composant de raccordement (37) destinée à visser le composant de raccordement (17) sur une partie filetée de connexion de courant correspondante de la connexion de courant (12).

13. Agencement d'adaptateur (10b ; 10c ; 10d ; 10e ; 10f) selon l'une des revendications 7 à 12,
dans lequel le composant de raccordement (17) est conçu en une seule pièce.

14. Agencement d'adaptateur (10d) selon l'une des revendications 7 à 13,
comportant un deuxième moyen d'acheminement de courant élastiquement déformable (32), la connexion de courant (12) et le composant de raccordement (17) étant mécaniquement reliés l'un à l'autre pour une connexion électrique entre la connexion de courant (12) et le composant de raccordement (17) par l'intermédiaire du deuxième moyen d'acheminement de courant (32).

15. Ensemble de composants (100), comportant un récipient de gaz (11) ayant une surface extérieure (13) et une connexion de courant (12) de type saillie, la connexion de courant (12), pour l'acheminement d'un courant électrique dans le récipient de gaz (11), s'étendant à partir d'un volume interne (40) du récipient de gaz (11) au-delà de la surface extérieure (13) du récipient de gaz (11), et un agencement d'adaptateur (10d) fixé à la surface extérieure (13) ainsi qu'à la connexion de courant (12) selon l'une des revendications précédentes.
